# EUROPEAN PATENT APPLICATION

(11) **EP 3 992 331 A1**
(43) Date of publication of application: **04.05.2022**
(21) Application number: 20204070.5
(22) Date of filing: 27.10.2020
(51) Int. Cl.: C23F 13/02, G01R 19/25, B63B 59/04, G01R 19/00, G01R 19/165

(54) **POTENTIAL MEASURING DEVICE AND METHOD**

(71) Applicant: Volvo Penta Corporation, 405 08 Göteborg (SE)
(72) Inventor: RÄFTEGÅRD, Viktor, 448 31 Floda (SE)
(74) Representative: Valea AB

(57) **Abstract**

The invention relates to a portable unit (450; 650) arranged to measure a value for polarized potential in a corrosion protection system comprising a protected structure (C), an anode (A) and a reference electrode (R), which portable unit (450; 650) is connectable to the protected structure and to the reference electrode.The portable unit (450; 650) is arranged toperform voltage measurements to detect and monitor an instant-off sequence, wherein the corrosion protection system is turned off for a predetermined time period (T₁) during normal operation. If an instant-off sequence is detected, then a voltage measurement is performed to measure a voltage signal representing a direct current potential curve for the corrosion protection system during the instant-off sequence. A step response (S) detected in the voltage signal during an initial IR drop and a subsequent voltage decay are analysed. An initial value for the voltage signal at the time of the step response is determined and displayed as a value for polarized potential (Uₚ). The invention further relates to a method for operating the unit.

## Description

### TECHNICAL FIELD

The present invention relates to a portable polarized potential measuring device and a method for measuring polarized potential using such a portable unit.

### BACKGROUND

Metallic components placed in a corrosive environment such as parts of marine propulsion units and immersed or underground metallic structures, for instance oil rigs or pipelines, will require some form of cathodic protection in order to eliminate or reduce the effects of corrosion of those parts or structures.

An efficient way of providing corrosion protection is the use of a method termed impressed current cathodic protection (ICCP). ICCP systems are often used on cargo carrying ships, tankers and larger pleasure craft. KR101066104B1 discloses the general principle for an ICCP system wherein a metal element and an anode are attached to a vessel and immersed in water. The metal element is connected to the negative terminal and the anode is connected to the positive terminal of a source DC electrical power to provide an electric depassivation current through an electrical circuit including the anode, the metal element and the electrolyte. In this way, the anode provides corrosion protection for the metal parts. By maintain a predetermined potential in the electrical circuit, the ICCP system can provide a desired protection level for the metal parts to be protected. Such ICCP systems can also be used for land-based structures such as underground pipelines.

In order to maintain a desired predetermined potential in the circuit, it is necessary to obtain a value for polarized potential. Measuring the protection potential of a sacrificial anode corrosion protection (CP) system is fairly straightforward. The ohmic potential drop, often termed IR drop, in the electrolyte between the anode and cathode in a CP system is relatively low. Hence, the inaccuracy when using a common multimeter becomes insignificant, especially if holding the reference electrode away from the anode and close to the cathodic structure. The IR drop is a potential drop due to solution resistance. It is the difference in potential required to move ions through the electrolyte. IR drop results from the electric current flow in ionic electrolytes like dilute acids, saltwater, certain types of soil, etc. The IR drop is an unwanted quality and it must be removed to obtain an accurate measurement of polarized potential.

With an ICCP, however, there is a large IR drop in the electrolyte that makes it practically impossible to get a true potential reading of the polarized potential. Therefore, ICCP systems usually operates by making instant-off potential readings at certain intervals in order to determine if it needs to adjust the current output to maintain a proper potential. The instant-off potential represents an effective on-potential with IR-drop compensation. Instant-off potential is measured by interrupting the current for a short period of time and measuring the potential immediately following the interruption of the CP rectifier. A common multimeter is not suitable for such measurements, as such multimeters are unable to display the instantaneous changes in potential following the current interruption.

To make an external measurement of the polarized potential, either to verify that the ICCP measures the potential correctly or to get a reading without having to connect to and interrupt the operation of the ICCP system the use of specialized equipment, e.g. a PicoScope ^{®}, is required. This equipment must be connected to a computer and requires training and knowledge on how to read off the true potential from a detected oscillating potential signal. This measuring process is complex, time consuming and is not very practical for use in the field, such as on-board smaller marine vessels or when checking a buried pipeline in a remote area.

The invention provides an improved potential measuring unit and a method for measuring polarized potential aiming to solve the above-mentioned problems.

### SUMMARY

An object of the invention is to provide a means and a method for measuring polarized potential in a corrosion protection system, which when applied to a corrosion protection system such as an impressed current corrosion protection system solves the above-mentioned problems.

The object is achieved by a portable polarized potential measuring unit and a method for performing the measurement according to the appended claims.

In the subsequent text, a cathodic protection system monitored by the portable polarized potential measuring unit is mainly described for application to a marine vessel. However, the inventive arrangement is also applicable to, for instance, marine structures, such as oil platforms, or underground structures, such as pipelines. The cathodic protection system involves an impressed current cathodic protection (ICCP) system which is operated using direct current (DC), wherein metal elements to be protected are connected to a negative terminal to form a cathode and a suitable anode is connected to a positive terminal of a source DC electrical power. In the subsequent text, the power source used for supplying DC power to the system is not necessarily a battery. The power source can be any suitable on-board or shore based source of DC electrical power such as a fuel cell or a source of alternating current (AC) provided with an AC/DC rectifier.

The invention is primarily described for application to a marine vessel with a propulsion system provided with a cathodic protection system in the form of an ICCP system. The marine propulsion system comprises at least one driveline housing that is at least partially submerged in water, a torque transmitting drive shaft extending out of each driveline housing and at least one propeller mounted on the drive shaft. The propulsion system can comprise any suitable type of drive unit, such as stern drives of azimuthing drives. If a propeller is used as an anode, then the at least one propeller is electrically isolated from its drive shaft and each electrically isolated propeller is connected to a positive terminal of a direct current power source. The vessel can comprise one or more driveline housings comprising a single drive shaft with a single propeller or counter-rotating propellers with coaxial drive shafts. The system provides cathodic protection, wherein each metallic component to be protected against corrosion is connected to a negative terminal of the DC power source. A control unit is arranged to regulate the voltage and/or the current output from the direct current power source.

The ICCP system comprises at least one anode that can be, for instance, hull mounted or at least one propeller that can be used as an anode. The at least one metallic component to be protected forms a cathode and can be the at least one driveline housing, at least one trim tab, a seawater intake, a swimming platform and/or at least a portion of the vessel hull. Note that this is a non-exclusive list of metallic components suitable for corrosion protection. At the same time, the ICCP arrangement provides marine growth protection for the at least one anode.

According to one aspect of the invention, the invention relates to a portable unit arranged to measure a value for polarized potential in a corrosion protection system. The corrosion protection system comprises a protected structure, an anode and a reference electrode, wherein the portable unit is connectable to the protected structure and to the reference electrode. Connection can be achieved by suitable plug-in connectors such as jacks or plugs which can be plugged into corresponding sockets or be wired to the respective component. In the case of a marine vessel/structure one connector can be connected to the protected structure, while the reference electrode is lowered into the electrolyte, i.e. the water.

The portable unit is arranged to perform voltage measurements in order to detect and monitor an instant-off sequence, wherein the corrosion protection system, such as an ICCP system is turned off for a predetermined time period during normal operation. An instant-off sequence can be initiated at regular or irregular intervals by a control system arranged to monitor and control the operation of the ICCP system, which intervals can vary from several seconds to minutes. The duration of an instant-off sequence can be a selected time period of e.g. 2 seconds, or the time taken to reach a 100 mV decay after initiation of an instant-off sequence.

If an instant-off sequence is detected, then the portable unit is arranged to perform voltage measurements during the instant-off sequence, wherein a voltage signal representing a direct current potential curve for the corrosion protection system during the instant-off sequence is measured. Data representing the voltage signal can be stored on a non-volatile memory in the portable unit. The portable unit is arranged to detect a step response in the voltage signal during an initial IR drop and subsequent voltage decay during the instant-off sequence. The IR drop is an ohmic potential drop that occurs when an impressed potential drops to a polarized potential during an instant-off sequence. An analysis of the detected step response in the voltage signal is performed. On the basis of this analysis, an initial value for the voltage signal at the time of the step response is determined. The portable unit is arranged to display the initial value as a value for polarized potential.

The portable unit is arranged to analyse oscillations and reduce noise in the voltage signal during the detected step response by means of an algorithm, in order to resolve the voltage signal into a series of data points during a settling time of the step response and to determine the initial value for the voltage signal at the time of the step response. The analysis and the signal processing are performed by a programmable processing device integrated in the portable unit. This initial value occurs at an instant in time after the current is switched off, at which time the potential will drop from the impressed potential applied by the ICCP system to the polarizing potential. The sudden drop in potential when the instant-off sequence is initiated causes noise, spikes and/or oscillations in the detected voltage signal when the voltage reaches the polarizing voltage. The voltage signal will initially try to settle at the polarizing voltage, but as the current has been switched off, the signal will immediately begin to decay. The algorithm will perform an analysis of the series of data points representing voltage variations following the step response in order to estimate a trend that allows an initial voltage value to be determined by tracing the trend in the data points backwards to the time of the step response.

The portable unit can further be arranged to determine the initial value for the voltage signal at the time of the step response by means of a curve fitting process applied to the series of data points. Curve fitting can involve either interpolation, where an exact fit to the data is required, or smoothing, in which a function is constructed that approximately fits the data. The portable unit can further perform a retrograde extrapolation using the fitted curve in the range of the observed data at the time of the step response to determine a value for the initial value representing the polarized potential at the time of the step response.

The portable unit is arranged to perform the signal detection and measurements described above during the settling time of the voltage signal following the step response. The time frame for performing these voltage measurements can be very short. Depending on where the measurements are performed, the settling time period can be from a few milliseconds (ms) up to 300 ms depending on parameters such as the resistivity of the electrolyte, the inherent inductance in the protected structure and the length of the same structure. For compact marine applications (marine vessels) where resistivity is relatively low the settling time period occurs within a few milliseconds. For long underground structures such as pipelines where resistivity can be relatively high the settling time period can be up to 300 ms.

As indicated above, the portable unit is connectable to the protected structure and to the reference electrode. A reference electrode is an electrode which has a stable and well-known electrode potential. A reference electrode is used as a half-cell to build an electrochemical cell, allowing the potential of the other half cell of the corrosion protection system to be determined. A non-exhaustive list of suitable reference electrodes and their reference potentials E for this purpose includes saturated calomel electrodes (Hg/HgCI(sat.KCI) or SCE) (E=+241 mV vs. SHE (saturated hydrogen electrode)), copper-copper sulphate electrodes (Cu-CuSO₄ or CSE) (E=+314 mV) and silver-silver chloride (Ag/AgCI) electrodes (E=+197 mV saturated).

According to one example, the portable unit is arranged to request a user input selecting a reference electrode type currently used. A reference electrode can be selected from a list of electrodes displayed by the unit. In this way, an initial value representing a value of the polarized potential for the current corrosion protection system is displayed to the user. Alternatively, the unit can use a default reference electrode pre-set by the user, or simply display a value for the currently measured potential.

According to a further example, the user can input an electrode selection other than the reference electrode type currently used in the corrosion protection system. The portable unit is then arranged to perform a measurement and to convert the determined value for polarized potential and will instead display a value for polarized potential for the selected type of reference electrode. This allows the polarizing potential for different protected structures to be compared, even if they are provided with different types of reference electrodes, e.g. if one wishes to know the potential versus a saturated calomel electrode while measuring using a silver-silver chloride (Ag-AgCI) electrode. A special case of this could be if measurements are done using a solid junction silver-silver chloride electrode and the temperature and salinity of the water is known. Entering those data would make it possible for the instrument to return a more accurate value since the electrode potential varies with temperature and salinity.

In addition to determining a value for polarizing potential for the corrosion protection system, the portable unit can also indicate the system status. According to one example, the portable unit can be arranged to determine that the corrosion protection system is an operational impressed current corrosion protection (ICCP) system if an instant-off sequence is detected and the determined value for polarized potential is equal to a desired value or within an allowable predetermined range of values. The latter example can be used in cases where polarized potential is likely to vary dependent on ambient conditions. The value of the polarized potential is also dependent on the metallic material in the protected structure and the type of reference electrode used. The allowable predetermined range can be selected dependent on whether the determined polarized potential is inside a known range that provides sufficient corrosion protection or not. Using an allowable range for the polarized potential can also be used to avoid hunting caused by small deviations from a desired value causing the ICCP system to perform multiple, possibly unnecessary, adjustments of the current output to maintain a constant desired polarized potential.

According to a further example, the portable unit can be arranged to determine that the ICCP system is operated in a back-up mode using one or more sacrificial anodes, e.g. following a power failure. If an instant-off sequence is detected but the determined initial IR drop towards the polarized potential is below a predetermined value, then it is assumed that the ICCP system is operated in a back-up mode. For pipeline applications where measurements are performed at a testing station, allowing contact with the protected structure, or for marine applications in general, the IR drop will be negligible. This means that the portable unit can detect that an IR drop has occurred but that its magnitude is insignificant compared to the IR drop of an operational ICCP system.

According to a further example, the portable unit can be arranged to determine that the corrosion protection system is a sacrificial anode corrosion protection system if an instant-off sequence is not detected.

According to a second aspect of the invention, the invention relates to a method for measuring a value for polarized potential in a corrosion protection system comprising a protected structure, an anode and a reference electrode, wherein a portable unit is connectable to the protected structure and to the reference electrode. According to the method, the portable unit performs the steps of:
- monitoring and detecting an instant-off sequence, wherein the corrosion protection system is turned off for a predetermined time period during normal operation; and
if an instant-off sequence is detected, then:
- performing voltage measurements during the instant-off sequence;
- measuring a voltage signal representing a direct current potential curve for the corrosion protection system during the instant-off sequence;
- detecting a step response in the voltage signal during an initial IR drop and a subsequent voltage decay during the instant-off sequence;
- analysing the detected step response in the voltage signal; and
- determining an initial value for the voltage signal at the time of the step response and displaying the initial value as a value for polarized potential.

The method can involve the further steps of:
- analysing oscillations and reducing noise in the voltage signal during the detected step response by means of an algorithm;
- resolving the voltage signal into a series of data points during a settling time of the step response; and
- determining the initial value for the voltage signal at the time of the step response.

The initial value occurs at the instant after the current is switched off, at which time the potential will drop to the polarizing potential. The sudden drop in potential when the instant-off sequence is initiated causes noise, spikes and/or oscillations in the detected voltage signal when the voltage reaches the polarizing voltage. The voltage signal will initially try to settle at the polarizing voltage, but as the current has been switched off, the signal will immediately begin to decay. The algorithm will perform an analysis of the series of data points representing voltage variations following the step response in order to estimate a trend that allows an initial voltage value to be determined by tracing the trend in the data points backwards to the time of the step response.

The method can further involve performing the further step of estimating the initial value for the voltage signal at the time of the step response by applying a curve fitting process to the series of data points. Curve fitting can involve either interpolation, where an exact fit to the data is required, or smoothing, in which a function is constructed that approximately fits the data. In addition, the method can involve applying a retrograde extrapolation to the curve fitting process. The retrograde extrapolation uses the fitted curve in the range of the observed data at the time of the step response to determine a value for the initial value representing the polarized potential at the time of the step response.

The method involves performing the signal detection and measurements described above during the settling time of the voltage signal following the step response. The time frame for performing these voltage measurements can be very short. Depending on where the measurements are performed, the settling time period can be from a few milliseconds (ms) up to 300 ms.

The arrangement according to the invention solves the problem of performing an external measurement of the polarized potential in the field without the need for specialized equipment, such as an oscilloscope, or the need of a personal or laptop computer for additional computing power and visualization means, required for allowing a user to interpret an output involving reading off a curve to determine a value for the polarizing potential. The portable unit according to the invention is merely required to be connected to a protected structure and a reference electrode, either directly or indirectly, using a pair of connectors or a connector wired to a reference electrode immersed in the electrolyte. If a voltage signal is detected, the unit can indicate a value for polarized voltage to the user directly.

The invention further allows the user to select the reference electrode type currently used. In this way, an initial value representing a value of the polarized potential for the current corrosion protection system is displayed to the user. Alternatively, the user can select other types of reference electrodes than that currently used in the corrosion protection system to be measured. When a reference electrode has been selected from a displayed list, the unit is arranged to perform a measurement and convert the determined value for polarized potential and display a value for polarized potential for the selected type of reference electrode. This allows the polarizing potential for different protected structures to be compared, even if they are provided with different types of reference electrodes.

If desired, the portable unit can also indicate status of the system. The portable unit can inform the user if the system operates correctly in ICCP mode, if there is a problem with the power supply for the ICCP system or if the system provides protection from a sacrificial anode only.

A further advantage is that the portable unit can be operated by an unskilled user given basic instructions on how to operate the device.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples. In the drawings:
- Fig. 1: shows a schematically illustrated vessel comprising a corrosion protection system;
- Fig. 2: shows a schematic electrical circuit for the corrosion protection system of the vessel in Figure 1;
- Fig. 3: shows a schematic propulsion system with a passive anode;
- Fig. 4: shows a schematic representation of a portable potential measuring unit connected to a vessel;
- Fig. 5: shows a schematically illustrated pipeline comprising a corrosion protection system;
- Fig. 6: shows a schematic representation of a portable potential measuring unit connected to a pipeline;
- Fig. 7A: shows a schematic diagram illustrating a step response following an instant-off sequence in an ICCP system; and
- Fig. 7B: shows an enlarged view of the step response in Figure 7A.

### DETAILED DESCRIPTION OF EXAMPLE EMBODIMENTS OF THE INVENTION

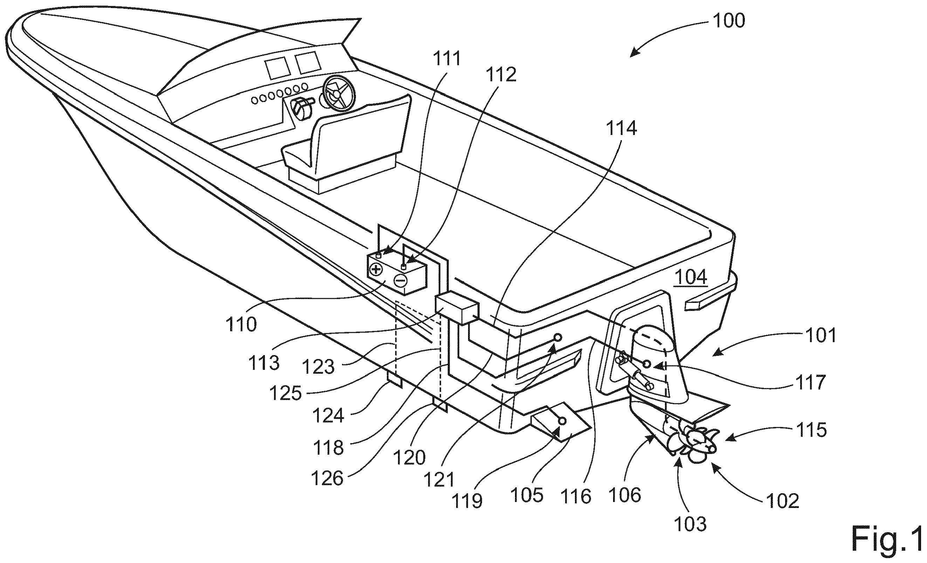

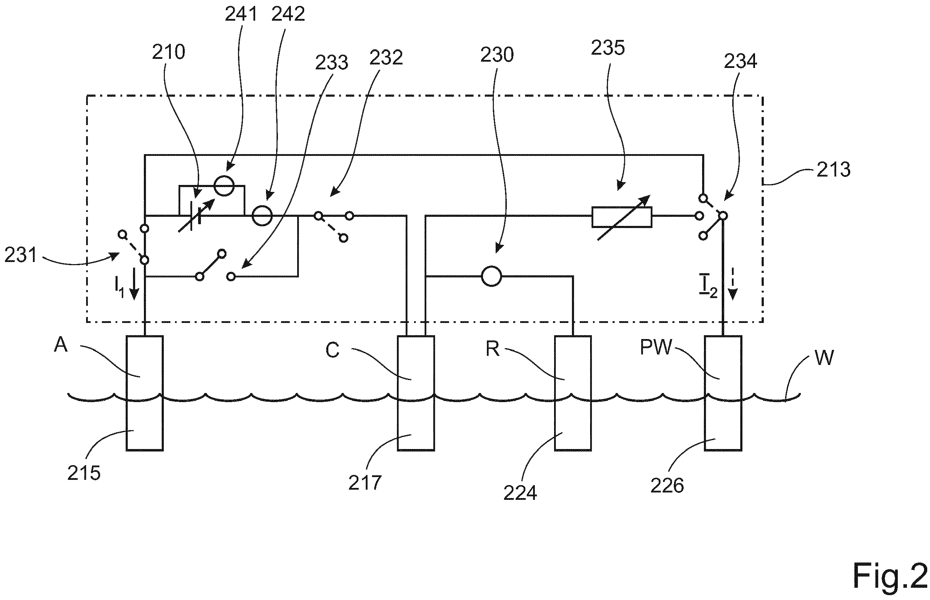

Figure 1 shows a schematically illustrated marine vessel 100 comprising cathodic protection system. The vessel comprises a hull with a transom 104 to which a marine propulsion system is attached. The propulsion system in this example comprises a single driveline housing 101 at least partially submerged in water, a torque transmitting drive shaft 106 (not shown) extending out of the driveline housing 101, and a pair of counter-rotating propellers 102, 103 mounted on the drive shaft 106. In the current example, both propellers 102, 103 are electrically isolated from its drive shaft 106. The drive shaft arrangement is shown in Figure 2 and will be described in further detail below. Each electrically isolated propeller 102, 103 to be protected against corrosion is connected to a negative terminal 112 of a direct current (DC) power source 110, such as a battery, in order to form a cathode. In the same way, each additional metallic component 101, 104, 105 to be protected against corrosion is connected to a negative terminal 112 of the direct current power source 110, in order to form cathodes. A control unit 113 is connected to the direct current power source 110 and distributes current to all component parts forming an electrical circuit. The control unit 113 is arranged to regulate the voltage and current output from the direct current power source 110. In order to assist regulation of the voltage and current output a reference electrode 124 is mounted on the hull and is connected to the control unit 113 via an electrical wire 123. The reference electrode is preferable mounted remote from the protected structure in order to achieve an even current distribution. The reference electrode 124 measures a voltage difference between itself and the metallic components, which is directly related to the amount of protection received by the anode. The control unit 113 compares the voltage difference produced by the reference electrode 124 with a pre-set internal voltage. The output is then automatically adjusted to maintain the electrode voltage equal to the pre-set voltage.

Regulation of the voltage and current output from the direct current power source is controlled to automate the current output while the voltage output is varied, or to automate the voltage output while the current output is varied. This allows the corrosion protection level to be maintained under changing conditions, e.g. variations in water resistivity, water temperature or water velocity. In a sacrificial anode system, increases in the seawater resistivity can cause a decrease in the anode output and a decrease in the amount of protection provided, while a change from stagnant conditions results in an increase in current demand to maintain the required protection level. With ICCP systems protection does not decrease in the range of standard seawater nor does it change due to moderate variations in current demand. An advantage of ICCP systems is that they can provide constant monitoring of the electrical potential at the water/protected structure interface and can adjust the output to the anodes in relation to this. An ICCP system comprising a reference electrode is more effective and reliable than sacrificial anode systems where the level of protection is unknown and uncontrollable.

The corrosion protection system in this example is an impressed current cathodic protection (ICCP) arrangement using the propellers 102, 103 as a cathode 115. In this example, hull mounted anodes (not shown) connected to the positive terminal 111 are used. In Figure 1, the metallic component to be protected against corrosion is the driveline housing 101, the trim tabs 105 (one shown), and a metal portion of the hull, in this case the transom 104. Note that this is a non-exclusive list of metallic components suitable for marine growth and corrosion protection. In order to achieve this, the positive terminal 111 and the negative terminal 112 of the battery 110 are connected to the control unit 113. The control unit 113 is arranged to connect the negative terminal 112 to the propellers 102, 103 via a first electrical wire 114. The control unit 113 is further arranged to connect the negative terminal 112 to an electrical connector 117 on the driveline housing 101 via a second electrical wire 116. The negative terminal 112 is also connected to an electrical connector 119 on the trim tab 105 via a third electrical wire 118, and is connected to an electrical connector 121 on the transom 104 via a fourth electrical wire 120. The corrosion protection system is further provided with a passive, sacrificial anode 126 that can provide protection if a failure occurs in the active anti-fouling arrangement. The sacrificial anode 126 can be located at any suitable location on the vessel and is connectable to the control unit 113 via a fifth electrical wire 125.

Figure 2 shows a schematic first representation of an electrical circuit for the corrosion protection system of the vessel in Figure 1 in its normal, active operating mode. A battery 210 is connected to, and adapted to provide electrical power to, an active anode 215 (A) and at least one cathode 217 (C) to be protected. This connection is provided via a control unit 213, which is adapted to vary and control the electrical power to the active anode 215 and the cathode 217, as indicated with an arrow adjacent the battery 210.

The control unit 213 is adapted to measure an electrical potential of the cathode 217 with a reference electrode 224 (R) as a ground reference. The electrical potential of the cathode 217 is measured using a voltage sensor 230. The electrical potential is indicative of the surface polarization at the interface between the cathode 217 and an electrolyte W; in this case water. The control unit 213 is further adapted to control the electrical power to the active anode 215 (A) and the cathode 217 (C) based at least partly on the measured electrical potential of the cathode 217 with the reference electrode 224 (R) as a ground reference. Through the control of the electrical power, a first electrical current (indicated by an arrow I₁ in Fig.2), through an electrical circuit comprising the active anode 215, the cathode 217 and the electrolyte W, is controlled.

More specifically, the parameter of interest for control of the corrosion protection of the cathode 217 is the electrical potential of the cathode 217 with the reference electrode as a ground reference, corresponding to the surface polarization at the interface between the cathode 217 and the water W, and the electrical power to the active anode 215 and the cathode 217 is subjected to a closed loop control so as for said surface polarization to assume a desired value.

Thus, the corrosion protection system for the cathode 217 comprises an ICCP system with the active anode 215, the reference electrode 224, the battery 210 and the control unit 213. In Figure 2 the schematic electrical circuit of the corrosion protection system is only shown to comprise a single cathode, in this case the drive 217. However, additional components to be protected, such as the trim tabs, the transom and other metallic components (see Fig.1) can be connected to the control unit 213 as cathodes in the same way as the drive 217.

The control unit 213 further comprises a number of controllable switches for controlling different functions of the corrosion protection system. A first switch 231 is arranged between the positive terminal of the battery 210 and the anode 215, which first switch 231 is normally closed to supply the anode with power during an active corrosion protection mode. When opened, the first switch 231 disconnects the active anode 215 from the positive terminal of the battery 210. A second switch 232 is arranged between the negative terminal of the battery 210 and the cathode 217, which second switch 232 is normally switched to a closed position to maintain a closed circuit including the active anode 215, the cathode 217 and the battery 210 during active corrosion protection mode, wherein a current I₁ flows from the battery 210 to the active anode 215. When opened, the second switch 232 can disconnect the cathode 217 from the negative terminal of the battery 210. A third switch 233 is arranged between the negative terminal of the battery 210 and the anode 215, which third switch 233 is normally open during active corrosion protection mode. When closed, the third switch 233 can connect the active anode 217 to the negative terminal of the battery 210. A fourth switch 234 is arranged to connect or disconnect a sacrificial, or passive anode 226 (PW) to or from the corrosion protection system. The fourth switch 234 is a three-position switch that is normally in a first position (lower contactor in Fig.2) during active corrosion protection mode, wherein the passive anode 226 is completely disconnected from the system. In a further position (central contactor in Fig.2), the passive anode 226 is connectable to the cathode 217 to provide passive corrosion protection.

The corrosion protection system for the cathode 217 comprises a passive corrosion protection system with the passive anode 226 and the control unit 213. Should a fault occur in the active corrosion protection system, then the fourth switch 234 is switched from its open position to a first closed position (centre contactor in Fig.2) to connect the passive anode 226 to the cathode 217. Prior to this action, or at least at the same time, the first switch 231 is controlled to its open position to disconnect the active anode 215 and the battery 210 from the cathode 217. This electrical circuit provides a passive back-up corrosion protection system for the vessel. As indicated above, the control unit 213 is adapted to measure electrical potential of the cathode 217 with the reference electrode 224 as a ground reference. The electrical potential is indicative of the surface polarization at the interface between the cathode 217 and the water W. The control unit 213 is further adapted to control an adjustable resistance 235 in the electrical connection between the passive anode 226 and the cathode 217 based at least partly on the measured second electrical potential of the cathode 217 with the reference electrode 224 as a ground reference. Through control of the adjustable resistance 235 an electrical current between the passive anode 226 and the cathode 217, herein also referred to as a second electrical current (indicated by a dashed arrow I₂ in Fig. 2), is controlled. Thus, the second electrical current I₂ runs through an electrical circuit comprising the passive anode 226, the cathode 217 and the electrolyte W during passive corrosion protection mode.

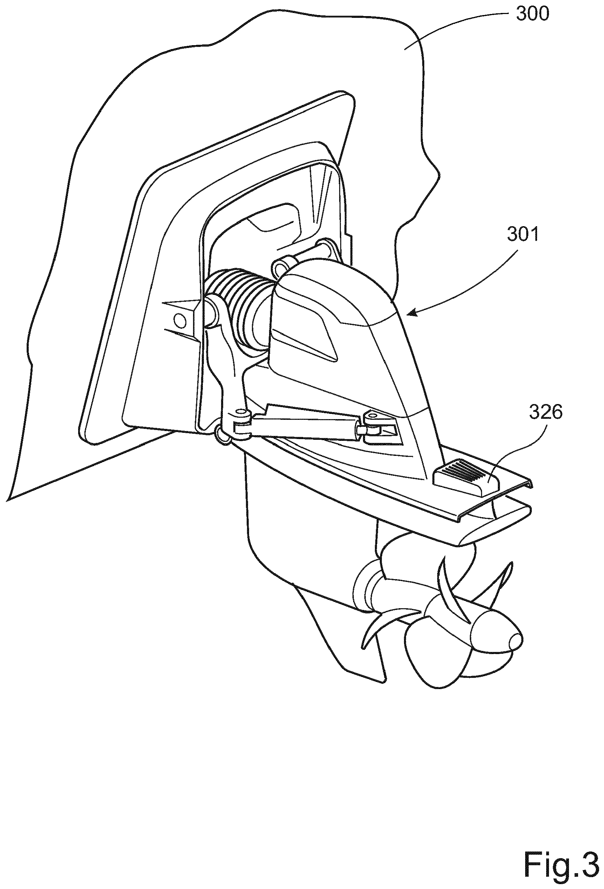

Figure 3 shows a schematic propulsion system 301 with a passive sacrificial anode 326. When connected to a vessel 300 with a propulsion system comprising a passive system, the portable unit will initially monitor the system for instant-off sequences. When this is not detected, the unit will assume that the impressed current corrosion protection (ICCP) system is operated in a back-up mode, using a sacrificial anode, or that it is connected to a passive corrosion protection system. The portable unit will then proceed to measure the protection potential of a sacrificial anode corrosion protection (CP) system. This is fairly straightforward since the ohmic potential drop, or IR drop, in the electrolyte between the anode and cathode is relatively low. A reading for the polarized potential of the passive corrosion protection system will then be displayed to the user.

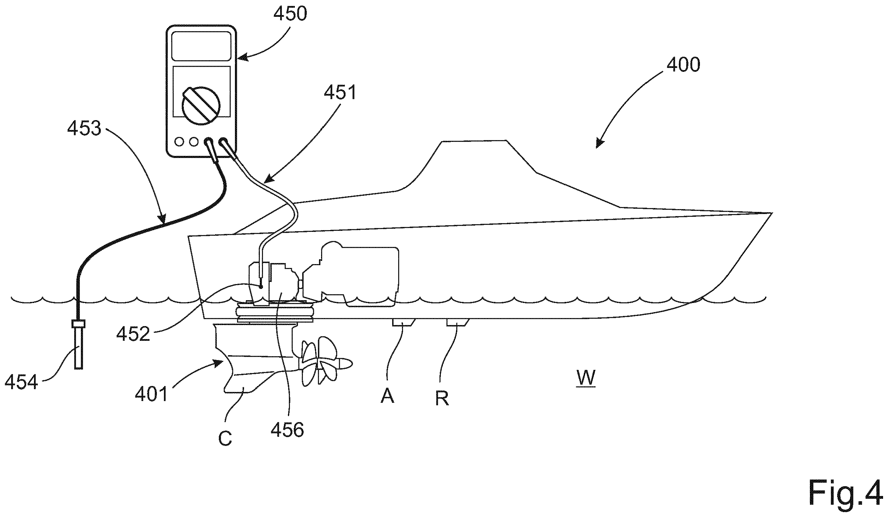

Figure 4 shows a schematic representation of a portable potential measuring unit 450 connected to a vessel 400. In this example, the portable unit 450 can be arranged to measure a value for polarized potential in a corrosion protection system as shown in Figure 2 or for a vessel as shown in Figure 1. The corrosion protection system in Figure 4 comprises a protected structure C in the form of a propulsion unit 401, an anode A and a reference electrode R mounted to the immersed portion of the hull of the vessel. The portable unit 450 comprises a first lead 451 having a free end provided with a suitable universal plug-in connector 452, such as a jack or plug, and a second lead 453 having a free end provided with a reference electrode 454 that can be immersed in the surrounding body of water W. Such a reference electrode can be used when the reference electrode R on the vessel is inaccessible or does not have a suitable socket for a plug-in connector. The plug-in connector 452 on the first lead 451 of the portable unit 450 is connected to a socket (not shown) on the protected structure C; in this case to a part of the transmission for the outer drive of the propulsion unit 401. The second lead 453 is connected to the immersed reference electrode 454. When the portable unit 450 has been connected to the corrosion protection system, the user can select the type of reference electrode R used by the system and initiate a measurement of the polarized potential. This procedure will be described in further detail below.

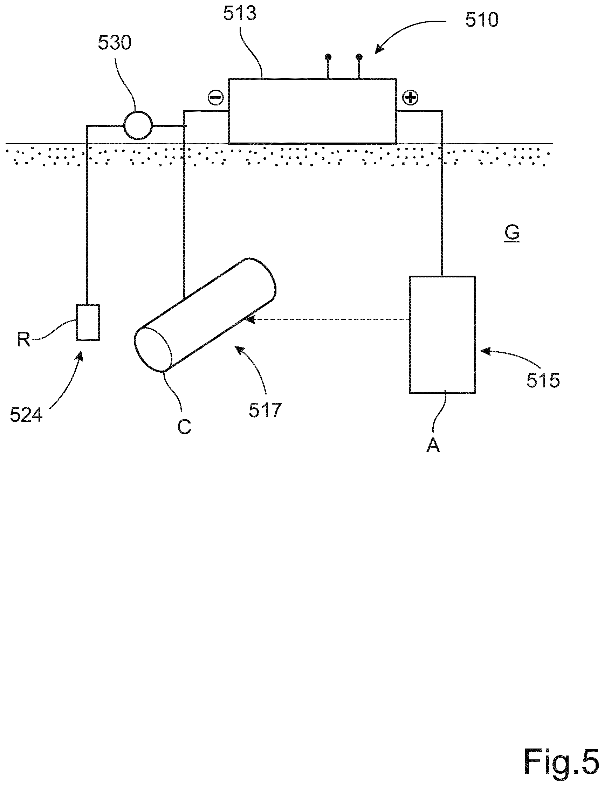

Figure 5 shows a schematically illustrated pipeline 500 comprising an impressed current corrosion protection (ICCP) system. A power supply 510 is connected to, and adapted to provide electrical power to, an active anode 515 (A) and at least one cathode 517 (C) to be protected. This connection is provided via a control unit 513, which is adapted to vary and control the electrical power to the active anode 515 and the cathode 517. The power supply 510 can be a source of DC power. Alternatively, the control unit 513 is connected to a source of AC power, e.g. the grid; in which case the control unit will be provided with an AC/DC power converter.

The control unit 513 is adapted to measure an electrical potential of the cathode 517 (C) with a reference electrode 524 (R) as a ground reference. The electrical potential of the cathode 517 is measured using a voltage sensor 530. The electrical potential is indicative of the surface polarization at the interface between the cathode 517 and an electrolyte G; in this case the surrounding ground. The control unit 513 is further adapted to control the electrical power to the active anode 515 (A) and the cathode 517 (C) based at least partly on the measured electrical potential of the cathode 517 (C) with the reference electrode 524 (R) as a ground reference. Through the control of the electrical power, the electrical current, through an electrical circuit comprising the active anode 215, the cathode 517 and the electrolyte G, is controlled. The parameter of interest for control of the corrosion protection of the cathode 517 is the electrical potential of the cathode 517 with the reference electrode 524 as a ground reference, corresponding to the surface polarization at the interface between the cathode 517 and the ground G, and the electrical power to the active anode 515 and the cathode 517 is subjected to a closed loop control so as for said surface polarization to assume a desired value. In this way, the corrosion protection system for the cathode 517 comprises an ICCP system with the active anode 515, the reference electrode 524, the power source 510 and the control unit 513. In Figure 5 the schematic electrical circuit of the corrosion protection system is only shown to comprise a single cathode, in this case the pipeline 517. However, additional ICCP system can be provided at regular intervals along the extension of the pipeline.

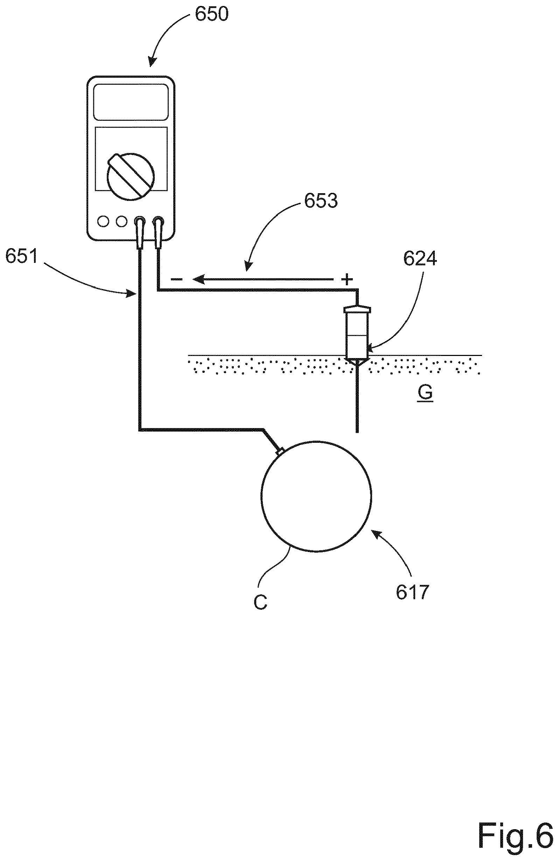

Figure 6 shows a schematic representation of a portable potential measuring unit 650 arranged to measure a value for polarized potential in a corrosion protection system as shown in Figure 5. The portable potential measuring unit 650 comprises a first lead 651 connected to a pipeline 617 (C) forming a cathode. A second lead 653 is connected to a reference electrode 624 (R). The reference electrode in this example is provided as a separate electrode 624 that is inserted into the soil above the protected structure. The reason for this is that it not practically possible in the field to connect the second lead to a local reference electrode. Figure 6 does not show any connectors for the first and second leads. However, as the wiring for the corrosion protection system is mainly located underground, some form of physical infrastructure comprising sockets for the leads can be provided at or near the control unit (see Fig.5). When the portable unit 650 has been connected to the corrosion protection system, the user can select the type of reference electrode R used by the system and initiate a measurement of the polarized potential. This procedure will be described in further detail below.

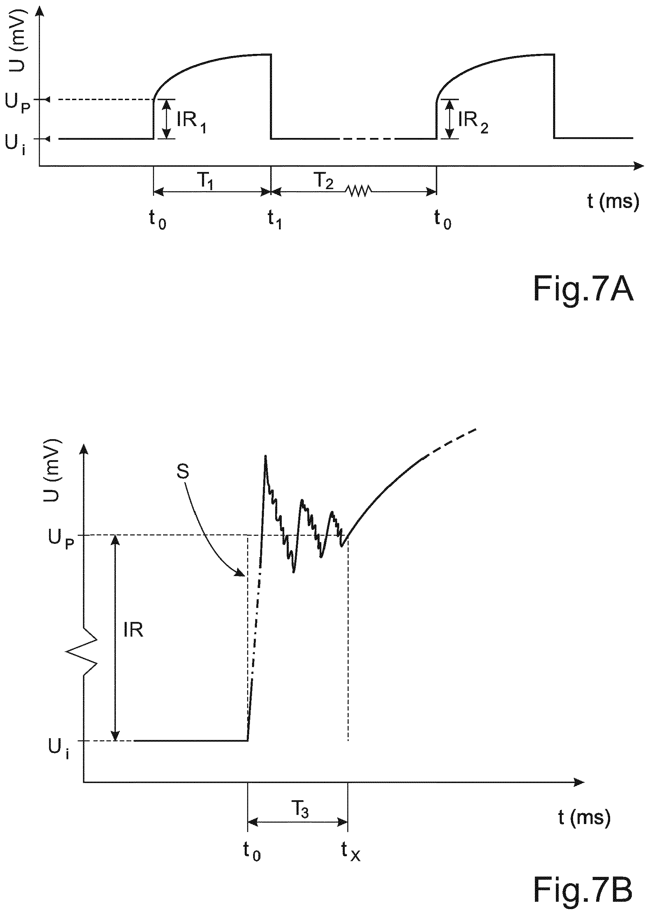

Figures 7A and 7B shows a schematic diagram illustrating a step response in a potential curve following an instant-off sequence in an ICCP system as described above. The potential curve in Figure 7A shows the variations in potential following an instant-off sequence. For ICCP systems it is a common standard (e.g. NACE) to apply a negative voltage shift of 100 mV to the freely corroding potential of the protected material. Hence, for mild steel in seawater a standard potential value for achieving protection is -800 mV measured using a saturated calomel electrode (SCE). A common protection criteria is -800 mV_{SCE} or below measured using a saturated calomel electrode (SCE), when allowing for a margin of, for example, 50-100 mV to ensure sufficient protection. A lower limit for polarized potential can be -1100 mV to avoid overprotection. A suitable value for polarized potential could also take, for instance, water temperature into account as the potential can increase by approximately 1 mV per degree Celsius. A target or desired potential Ut that provides a desired amount of corrosion protection is preferably equal to the actual, or true, value for the polarized potential Uₚ.

With an ICCP system there is a large ohmic potential drop, or IR drop, in the electrolyte (water or soil) that makes it practically impossible to get a true potential reading of the polarized potential. As described above, the IR drop is a potential drop due to solution resistance. It is the difference in potential required to move ions through the electrolyte. IR drop results from the electric current flow in ionic electrolytes like dilute acids, saltwater, certain types of soil, etc. The IR drop is an unwanted quality and it must be removed to obtain an accurate measurement of polarized potential. During operation of the ICCP system, a control unit will impress a current onto the anode and creating a negative cathodic voltage, or impressed potential Uᵢ. The impressed potential Uᵢ will be greater than the value of polarized potential Uₚ in order to compensate for the IR drop. Therefore, ICCP systems are operated by making instant-off potential readings at certain intervals in order to determine if it needs to adjust the current output to maintain a desired or target polarized potential Ut. The instant-off potential represents an effective on-potential, without the IR-drop compensation. The value of polarized potential is measured by interrupting the current for a short period of time and measuring the potential immediately following the interruption of the CP rectifier.

The potential curve in Figure 7A illustrates an ICCP system being operated at an impressed potential Uᵢ. The impressed potential Uᵢ can vary depending on the current state of the anode or cathode, the amount of marine growth and/or ambient conditions, such as temperature and salinity. Typically, the impressed potential Uᵢ for a steel structure can be in the range -1000 to -1200 mV. At the time to an instant-off sequence is initiated, causing a step response S (see Fig.7B) during which the curve will drop from the impressed potential Uᵢ to the value of polarizing potential Uₚ. The difference between the potentials is the IR drop IR₁. As indicated in Figure 7A, the IR drop can vary in successive measurements, as illustrated by the subsequent instant-off sequence and the IR drop IR₂. Consequently, monitoring and adjustment of the impressed potential Uᵢ is required. The potential measuring unit will measure the potential over a time period T₁ until the time t₁ when the instant-off sequence ends. The duration T₁ of an instant-off sequence can be a selected time period of e.g. 2 seconds, or the time taken to reach a 100 mV decay after instant-off. A subsequent instant-off sequence is performed after an intermediate second time period T₂, which may be e.g. 10 seconds. The voltage signal during the relatively longer second time period is indicated by a dashed line in Figure 7A.

Figure 7B shows an enlarged view of the step response S schematically indicated in Figure 7A. The portable unit is arranged to perform the signal detection and measurements described above during a settling time period T₃ of the voltage signal following the step response S. The time frame for performing these voltage measurements between the time to of initializing the step response S until the time tₓ at the end of the settling time period T₃ can be a few milliseconds. The portable unit is then arranged to analyse oscillations and reduce noise in the voltage signal during the detected step response S by means of an algorithm, in order to resolve the voltage signal into a series of data points during a settling time T₃ of the step response and to determine the initial value for the voltage signal at the time of the step response. The analysis and the signal processing are performed by a processing device in the portable unit. This initial value occurs at the instant after the current is switched off, at which time the impressed potential Uᵢ will drop to the polarizing potential Uₚ. The sudden drop in potential when the instant-off sequence is initiated causes noise, spikes and/or oscillations in the detected voltage signal, as schematically indicated in Figure 7B, when the voltage reaches the polarizing voltage. The voltage signal will initially try to settle at the polarizing voltage Uₚ, but as the current has been switched off, the signal will immediately begin to decay. The algorithm will perform an analysis of the series of data points representing voltage variations following the step response S in order to estimate a trend that allows an initial voltage value to be determined by tracing the trend in the data points backwards to the time of the step response.

The accuracy of the initial value for the voltage signal at the time to of the step response S can be improved by means of a curve fitting process applied to the series of data points. Curve fitting can involve either interpolation, where an exact fit to the data is required, or smoothing, in which a function is constructed that approximately fits the data. A retrograde extrapolation using the fitted curve in the range of the observed data at the time of the step response can be performed to determine a value for the initial value representing the value of polarized potential Uₚ at the time t₀ of the step response.

The initial value representing the value of polarized potential Uₚ determined by the above process is then displayed to the user. If the determined polarizing potential Uₚ differs from the desired polarizing potential Ut, or is outside an allowable polarizing potential range, then the control unit will adjust the impressed potential Uᵢ up or down accordingly. For example, when the protected cathode is a steel structure immersed in seawater, then an expected polarized potential is -800 mV if the selected reference electrode is of the saturated calomel electrode (SCE) type. Alternatively, when the protected cathode is a steel structure buried in soil, then an expected polarized potential is -850 mV if the selected reference electrode is of the Cu/CuSO₄ type. As described above, the user can be prompted to input the type of reference electrode used during the measurement.

As a result of the measurements and the interpretation of the potential curve, the portable unit can also indicate the system status. According to one example, the portable unit can be arranged to determine that the corrosion protection system is an operational ICCP system if an instant-off sequence is detected and the determined value for polarized potential is within an allowable predetermined range. According to a further example, the portable unit can be arranged to determine that the corrosion protection system is an ICCP system operated in a back-up mode, using a sacrificial anode, if an instant-off sequence is detected but the initial IR drop towards the polarized potential is below a predetermined value. The predetermined value can be set relatively low as the IR drop for an ICCP system operating in a back-up mode is negligible compared to the corresponding value for an operational system. This can indicate a power supply problem or failure relating to an AC/DC rectifier, a shore power connection or insufficient battery charge. According to a further example, the portable unit can be arranged to determine that the corrosion protection system is a non-operational ICCP system if an instant-off sequence is not detected and the determined value for polarized potential is constant and below the predetermined range. In this way, the unit is able to measure a DC voltage and to interpret the measured potential signal for a structure connected to an ICCP system that operates using instant-off potential measurements and read off the value of polarized potential from that curve. The unit will also tell the user whether the system is operational in an ICCP mode or provides protection from a sacrificial anode only.

It is to be understood that the present invention is not limited to the embodiments described above and illustrated in the drawings; rather, the skilled person will recognize that many changes and modifications may be made within the scope of the appended claims.

## Claims

1. Portable unit (450; 650) arranged to measure a value for polarized potential in a corrosion protection system comprising a protected structure (C), an anode (A) and a reference electrode (R), which portable unit (450; 650) is connectable to the protected structure and to the reference electrode;
**characterized in that** the portable unit (450; 650) is arranged to- perform voltage measurements to detect and monitor an instant-off sequence, wherein the corrosion protection system is turned off for a predetermined time period (T₁) during normal operation; and
if an instant-off sequence is detected, then the portable unit is arranged to:
- perform voltage measurements during the instant-off sequence;
- measure a voltage signal representing a direct current potential curve for the corrosion protection system during the instant-off sequence;
- detect a step response (S) in the voltage signal during an initial IR drop and a subsequent voltage decay during the instant-off sequence;
- analyse the detected step response (S) in the voltage signal; and
- determine an initial value for the voltage signal at the time of the step response and display the initial value as a value for polarized potential (Uₚ).

2. Portable unit according to claim 1, **characterized in that** the portable unit is arranged to analyse oscillations and reduce noise in the voltage signal during the detected step response (S) by means of an algorithm, in order to resolve the voltage signal into a series of data points during a settling time (T₃) of the step response and to determine the initial value (Uₚ) for the voltage signal at the time (t₀) of the step response.

3. Portable unit according to claim 2, **characterized in that** the portable unit is arranged to determine the initial value for the voltage signal at the time of the step response by means of a curve fitting process applied to the series of data points.

4. Portable unit according to claim 3, **characterized in that** the portable unit is arranged to apply a retrograde extrapolation to the curve fitting process.

5. Portable unit according to one of claims 1-4, **characterized in that** the portable unit is arranged to request a user input selecting a reference electrode type currently used.

6. Portable unit according to claim 5, **characterized in that** the portable unit is arranged to convert the determined value for polarized potential to a value for polarized potential for a selectable type of reference electrode other than the reference electrode currently used.

7. Portable unit according to claim 1, **characterized in that** the portable unit is arranged to determine that the corrosion protection system is an operational impressed current corrosion protection system if an instant-off sequence is detected and the determined value for polarized potential (Uₚ) is within a predetermined range.

8. Portable unit according to claim 1 or 7, **characterized in that** the portable unit is arranged to determine that the impressed current corrosion protection system is operated in a back-up mode, using a sacrificial anode, if an instant-off sequence is detected and the initial IR drop towards the polarized potential is below a predetermined value.

9. Portable unit according to any one of claims 7 or 8, **characterized in that** the portable unit is arranged to determine that the corrosion protection system is a sacrificial anode corrosion protection system if an instant-off sequence is not detected and the determined value for polarized potential is below the predetermined range.

10. Method for measuring a value for polarized potential in a corrosion protection system comprising a protected structure, an anode and a reference electrode, wherein a portable unit is connectable to the protected structure and to the reference electrode;
**characterized by** the portable unit performing the steps of: - monitoring and detecting an instant-off sequence, wherein the corrosion protection system is turned off for a predetermined time period (T₁) during normal operation; and
if an instant-off sequence is detected, then:
- performing voltage measurements during the instant-off sequence;
- measuring a voltage signal representing a direct current potential curve for the corrosion protection system during the instant-off sequence;
- detecting a step response (S) in the voltage signal during an initial IR drop (IR₁) and a subsequent voltage decay during the instant-off sequence;
- analysing the detected step response (S) in the voltage signal; and
- determining an initial value for the voltage signal at the time (to) of the step response (S) and displaying the initial value as a value for polarized potential (Uₚ).

11. Method according to claim 10, **characterized by** performing the further step of: analysing oscillations in the voltage signal during the detected step response by means of an algorithm and resolving the voltage signal into a series of data points during a settling time of the step response and to determining the initial value for the voltage signal at the time (to) of the step response (S).

12. Method according to claim 10 or 11, **characterized by** performing the further step of: estimating the initial value for the voltage signal at the time of the step response by applying a curve fitting process to the series of data points.

13. Method according to claim 12, **characterized by** performing the further step of: applying a retrograde extrapolation to the curve fitting process.
